# EUROPÄISCHE PATENTANMELDUNG

(11) **EP 1 130 643 A2**
(43) Veröffentlichungstag der Anmeldung: **05.09.2001**
(21) Anmeldenummer: 01105300.6
(22) Anmeldetag: 05.03.2001
(51) Int. Cl.: H01L 23/373

(54) **Aufbau von Leistungshalbleitern mit einer Ausgleichsschicht zum Kühlkörper**

(30) Priorität: 03.03.2000 DE 10010463; 05.10.2000 DE 10049397
(71) Anmelder: D-Tech GmbH Antriebstechnik und Mikroelektronik, 33689 Bielefeld (DE)
(72) Erfinder: Gabriel, Rupprecht, 33813 Oerlinghausen (DE)
(74) Vertreter: Leonhard, Frank Reimund, Dipl.-Ing.

(57) **Zusammenfassung**

Vorgeschlagen wird eine Vorrichtung mit zumindest einem flächigen Halbleiter (3,4,5) für die Leistungselektronik und einem zur Wärmeaufnahme oder Wärmeabfuhr geeigneten Metallsubstrat (1a,1b,1c), wobei das Metallsubstrat eine für eine Lötung (9) ausgebildete und dem flächigen Halbleiter zugewandte, kühlende Oberfläche (1b") aufweist. Der flächige Halbleiter hat eine zur lötfähigen Oberfläche (1b") ausgerichtete Substratseite (3b). Zwischen Substratseite (3b) und der als Kühlfläche dienenden lötfähigen Metalloberfläche (1b") ist eine Ausgleichsschicht (2a,2b) angeordnet. Die Ausgleichsschicht (2a,2b) weist eine textile metallische Schicht auf, die einen Anteil an metallischen, lötfähigen Fasern enthält, zur Verbindung zumindest der Substratseite (3b) des flächigen Halbleiters (3) mit einer ersten Oberfläche der Ausgleichsschicht (2a,2b) und der Kühlfläche (1b") des Metallsubstrats (1b) mit einer zweiten Oberfläche der Ausgleichsschicht (2a,2b).

## Beschreibung

Die Erfindung befaßt sich mit einer Vorrichtung zur Kopplung eines flächigen Halbleiterchips auf einem Kühlsubstrat, wobei gleichzeitig stromtragfähige Kontaktstellen zur Verfügung gestellt werden sollen.

Bisher werden für Hochleistungshalbleiter verschiedenstartige Druckkontakte eingesetzt. Hierbei ist es jedoch notwendig, eine dauerhafte Druckverbindung mit möglichst mehrfachen Kontaktflächen zu erreichen, was eine einfache und kosteneffiziente Lösung weitgehend ausschließt.

Zur Vermeidung von Druckkontakten sind bisher Lötverbindungen bekannt, die auf der Unterseite (Substratseite) des Halbleiterchips angeordnet werden. Dabei werden bei kleineren Geometrien die Leistungshalbleiter auf Kupferflächen oder zur besseren Anpassung der thermischen Ausdehnungskoeffizienten auf einem Zwischenträger aufgelötet. Der Zwischenträger soll die unterschiedlichen thermischen Ausdehnungen des Halbleiterkristalls und der Kühlfläche mindern oder ausgleichen; meist ist der Zwischenträger aus Molybdän. Je größer die zu schaltenden Leistungen aber werden, desto wichtiger wird es, die Anpassungen der unterschiedlichen thermischen Ausdehnungskoeffizienten in Betracht zu ziehen und zu vermeiden, daß durch diese unterschiedlichen Ausdehnungskoeffizienten bei stark erhöhter Leistung mechanische Brüche oder Beschädigungen am Halbleiterkristall auftreten. Ausgegangen wird dabei zumeist von einem Metall als Kühlsubstrat und einem Silizium als Halbleiterkristall. Einfache Schichten oder Zwischenträger aus Molybdän sind für solche große Leistungen nicht mehr ausreichend, insbesondere dann nicht, wenn erhöhte Temperaturen durch die erhöhten Leistungen in kauf genommen werden müssen.

Die von der Substratseite abgewandte Seite (die gegenüberliegende Seite) des Leistungshalbleites wird typischerweise mittels Dickdrahtbonden kontaktiert und die Bonddrähte mit einer weiteren Leiterfläche lateral verbunden. Hierbei wird eine gute Streßfestigkeit unter thermischem Streß erreicht, allerdings eignet sich eine solche Verbindung nicht für eine zusätzliche Abfuhr von Wärme aus dem Halbleiterchip, so daß die wesentliche Wärmeabfuhr weiterhin über die Substratseite des flächigen Halbleiterchips erfolgt.

Die **technische Aufgabe** sieht die Erfindung darin, eine gute thermische Ankopplung des Leistungshalbleiters an das kühlende Substrat zu erreichen, wobei eine Anpassung der unterschiedlichen Ausdehnungskoeffizienten der unterschiedlichen Materialien so erreicht werden soll, daß keine thermisch veranlaßten mechanischen Spannung innerhalb des Halbleiters auftreten.

Erreicht wird das mit einer Vorrichtung gemäß Anspruch 1, mit einer erfindungsgemäßen Verwendung nach Anspruch 19 oder mit dem Leistungshalbleiteraufbau nach Anspruch 20.

Als wesentliche vorteilhafte Wirkung bei dem Aufbau und der Verbindung des Leistungshalbleiters ist eine durch die Erfindung erreichte gute "thermische Anbindung" (Kopplung) des Halbleiters zu erwähnen, welche thermische Anbindung zu einem wärmeabführenden Medium (Substrat) führt, das gleichzeitig auch eine gute elektrische Verbindung zu den Anschlußklemmen erlaubt, die widerstandsarm sind. Es soll im folgenden die Verbindung unterschieden werden in eine thermische Verbindung im Sinne einer wärmeleitenden Verbindung und in eine stromtragfähige Verbindung, im Sinne einer elektrisch leitfähigen Verbindung, wobei beides auch gemeinsam an derselben Stelle erreicht werden kann.

Mit der erfindungsgemäß vorgesehenen Verwendung von Metalltextilien, also einer textilen, metallischen Verbindung, die erfindungsgemäß sowohl einseitig, wie auch beidseitig am Halbleiter vorgesehen sein kann, wird der thermische Ausdehnungskoeffizient des Kühlkörpers an den thermischen Ausdehnungskoeffizient des Halbleiters angepaßt. Das Metalltextil nimmt als Dehnungsschicht einen Ausgleich vor, ohne daß innere mechanische Spannungen auftreten, die zu Rissen, Brüchen oder sonstigen mechanischen Schäden führen, die die Wärmeleitung nachhaltig beeinflussen. Das metallische Textil kann Wärme ausgezeichnet leiten, ebenso wie Strom, gleichzeitig erlaubt es ein Verrücken oder Versetzen der angelöteten Oberfläche von Halbleiter und Kühlkörper, ohne daß mechanische Spannungen auftreten. Die im Verbund stehenden Fasern verlagern sich dabei zueinander, wobei die Verlagerung in dem Höhenbereich der Ausgleichsschicht stattfindet, die nicht durch eine Lötschicht fixiert ist. Die Lötschicht ist nur an der Oberfläche und bis zu einem geringen Grad auch in die Metalltextilschicht hinein vorgesehen, um die elektrische Kontaktierung zu sichern. Auch können durch die Metalltextilschicht Ungenauigkeiten an der Oberfläche vorteilhaft ausgeglichen werden.

Die unterschiedlichen thermischen Ausdehnungen des Siliziums und der Anschlußflächen werden durch großflächige textile Verbindungen kompensiert. Die textilen Verbindungen sind z.B. Nadelfilze aus Kupfer, gewebte oder geflochtene Kupferbänder oder zu Platten oder Bändern gepreßte Kupferwolle (Ansprüche 3,4,5 und 6). Die Fasern sind als Metallfasern in einem inneren Verbund zusammengehörig. Der innere Verbund ist ein Vlies oder ein Gewebe, so daß eine gegenseitige Verlagerung der Fasern möglich ist.

Der Begriff der metalltextilen Verbindung setzt sich aus der Verwendung von metallischen Fasern und der Zusammengehörigkeitsstruktur eines Textils zusammen. Der Begriff eines Textils soll nicht bedeuten, daß Textilfasern Verwendung finden, vielmehr werden solche Fasern verwendet, die Strom und/oder Wärme zu leiten vermögen. Diese werden in einen textilen Verbund gestellt, der eine Kompensation der unterschiedlichen thermischen Ausdehnung der beiden diesseits und jenseits angeordneten Flächen ermöglicht.

Die metalltextilen Verbindungen (im Sinne von thermischen und/oder elektrischen Kopplungen) lassen sich beidseitig anordnen, was eine wesentlich verbesserte thermische Anbindung ermöglicht und einen sicheren Betrieb des Halbleiters erreicht. Die textilen Verbindungen lassen sich beidseitig auf einen Basisträger (meist Kupfer oder Kupferlegierung) und den Halbleiter löten.

Ein nur teilweises Eindringen der Lötschicht in die metalltextile Faserschicht beläßt eine Zwischenlage, die in sich beweglich bleibt und dennoch eine mechanisch stabile Verbindung erreicht. Die innere Beweglichkeit wird dazu ausgenutzt, Verschiebungskräfte durch unterschiedliche thermische Ausdehnung aufzunehmen. Die Lötverbindung ist dabei so stabil, daß sie auch ohne eine zusätzliche kräftemäßige Beanspruchung des Halbleiters zur Schaffung von guten Wärmekontaktübergängen arbeitsfähig ist.

Es ist auch möglich, eine Kraft alleine zur Verbindung der Halbleiter und ihrer Kühlflächen zu verwenden, wenn eine Zwischenlage aus dem Metalltextil Verwendung findet. Hierbei entfallen die Lötschichten als Verbindungsschicht, können aber als stromtragfähige Verbindungen mit einer begrenzten Erstreckung weiterhin Einsatz finden.

Die Fertigung läßt sich erfindungsgemäß so durchführen, daß alle elektrischen Verbindungen (die stromtragfähigen Verbindungen) des Leistungshalbleiters in einem einzigen Arbeitsschritt durch Löten hergestellt werden. Dabei wird auf den Leistungshalbleiter beidseitig eine lötfähige Schicht aufgebracht, welche Leistungshalbleiter dann in einem Vakuumverfahren aufgelötet werden.

Nachdem moderne Leistungshalbleiter typisch eine aktive Fläche an der Oberfläche besitzen, wird in diesem Bereich ein Großteil der Verluste erzeugt. Bei MOS und bei IGBT-Transistoren ist es also sehr sinnvoll, eine beiderseitige Kühlung bereitzustellen. Selbst wenn aber nur eine einseitige Kühlung mit einer metalltextilen Zwischenschicht verwendet wird, wird gegenüber dem Stand der Technik eine deutlich verbesserte Erhöhung der Zuverlässigkeit des fertigen mechanischen Aufbaus erreicht. Die erfindungsgemäße Anordnung hat daher mehrere wesentliche Vorteile. Es können Halbleiter von beiden Seiten gekühlt werden. Es können zusätzliche elektrische Verbindungen gleichzeitig mit der thermischen Kopplung erreicht werden, die großflächig und damit unempfindlich gegen Migrationseffekte sind. Es wird in der entstehenden Sandwich-Bauweise erreicht, alle elektrischen Verbindungen in einem einzigen Arbeitsgang zu schaffen und nicht wie bisher seriell durch Bonddrähte erstellen zu müssen, was die Fertigungskosten deutlich herabsetzt.

Es können mehrere Halbleiter gleichzeitig thermisch gekoppelt werden, sowohl in einer Kaskade, als auch parallel. Eine Seriellschaltung erfolgt unter Aneinanderreihung von mehreren Sandwich-Aufbauten gemäß Anspruch 1. Eine parallele Anordnung erfolgt dadurch, daß mehrere Halbleiter ohne oder ohne wesentlichen Abstand voneinander auf derselben Ausgleichsschicht angeordnet werden und zusammen mit dieser Schicht verlötet werden. Auch hier kann eine einseitige oder zweiseitige Anbindung thermischer oder stromtragfähiger Natur erfolgen. Die Halbleiter werden dabei durch die Lötschicht thermisch und elektrisch zusammengeschaltet, als wären sie ein großer einziger Halbleiter mit einer Gesamtfläche, die als Summe der Einzelhalbleiter entsteht. Ein besonders kompakter Aufbau wird erzielt, nachdem kein lateraler Abstand zwischen den Einzelhalbleitern nötig ist (Anspruch 8).

Die Verbindung durch das Metalltextil ist sowohl als stromtragfähige, wie auch als wärmeleitende Verbindung geeignet (Anspruch 7). Zusätzlich Kontaktstellen am Leistungshalbleiter können ebenfalls kontaktiert werden (Anspruch 12,13,14 und 17). Die weitere elektrische Anschlußfläche kann bei steuerbaren Leistungshalbleitern dazu dienen, den Steueranschluß gesondert von der übrigen metallischen Kontaktierung, d.h. unabhängig, zu kontaktieren. Hierzu wird eine flächige Verbindungsschicht verwendet, die innen eine elektrische Kontaktierung bereitstellt, die aber zu beiden Seiten elektrisch isoliert ist, um durch die Lötschicht hindurch einen Kontaktpunkt am Halbleiter zu erreichen. Hier findet eine Lötverbindung statt. An dieser Stelle weist die Verbindungsschicht eine Öffnung auf, die eine Lötung mit der innen angeordneten Leiterbahn erlaubt.

Die zusätzliche Verbindungsschicht kann kleiner als die Ausgleichsschicht ausgebildet sein, wodurch um sie herum eine thermische und auch eine elektrisch leitfähige Verbindung erreicht wird. Die unterschiedliche Höhe nimmt das Fasergeflecht aus den Metallfasern ohne weiteres durch eine Verwirkarbeit auf, es gibt insoweit über die Fläche verteilt ungleichmäßig nach, namentlich dort, wo die zusätzliche Verbindungsschicht eingelegt ist.

Wird der Halbleiter beidseitig kontaktiert, wird zumindest eine weitere Ausgleichsschicht verwendet (Anspruch 10,11).

Werden mehrere Halbleiter seriell kontaktiert, werden für jeden Halbleiter zumindest eine, meist zwei Ausgleichsschichten verwendet.

Ausführungs**beispiele** erläutern die Erfindung anhand von Figuren.
- Figur 1: veranschaulicht einen Querschnitt durch einen Aufbau aus Leistungshalbleiter und Kühlsubstraten, die beispielsweise durch Kühlkörper gebildet werden können.
- Figur 2: veranschaulicht einen Querschnitt aus mehreren seriell geschalteten Leistungshalbleitern 3,4.
- Figur 3: veranschaulicht eine Parallelschaltung von mehreren Leistungshalbleitern 4,5,6,7 und 8.
- Figur 4: veranschaulicht einen Aufbau gemäß Figur 1, hier mit einer zusätzlichen flächigen Verbindungsstruktur 10.
- Figur 5: veranschaulicht im Querschnitt die flächige Verbindungsstruktur 10 von Figur 4.
- Figur 6: veranschaulicht einen Ausschnitt aus den Figuren 1,2,3 oder 4, wobei die Lötschichten 9 an der Ausgleichsschicht 2b vergrößert dargestellt sind, um ihre Eindringtiefe d1 zu verdeutlichen.

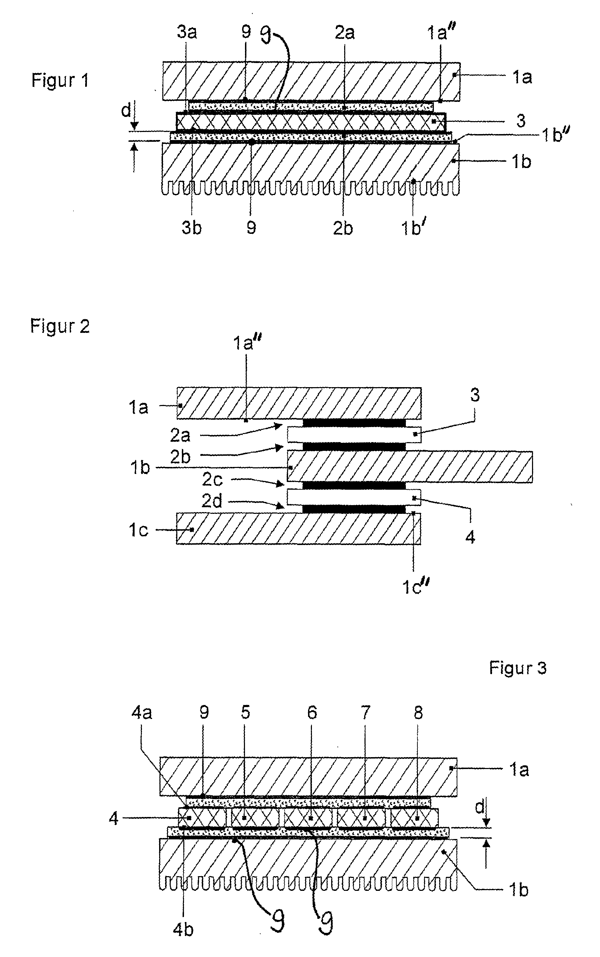

**Figur 1** zeigt einen Querschnitt durch ein Beispiel eines ersten Aufbaus. Gezeigt ist ein Metallsubstrat 1b mit einer metallischen Fläche 1b", das Wärme und ggf. Strom aufzunehmen vermag. Als Beispiel ist der Halbleiter 3 eine Diode. Diese besitzt an ihrer einen Fläche 3a eine Anode und an ihrer zweiten Fläche 3b eine Kathode. Die oben und unten von dem Halbleiter 3 angeordneten Metallsubstrate 1b und 1a dienen der Wärmeabfuhr nach außen oder als Wärmepuffer. Dabei sind die Metallsubstrate so zu verstehen, daß sie entweder schon selbst Kühlkörper sein können, oder Basisträger, die zwischen Halbleiter 3 und einem noch zusätzlich hinzugenommenen Kühlkörper oder solchen Finnenbereich 1b' liegen.

Zwischen dem Halbleiter 3 und dem oberen Metallsubstrat 1a bzw. seiner unteren Oberfläche 1a" sowie zwischen dem Halbleiter 3 und dem unteren Kühlsubstrat 1b, bzw. dessen oberer Oberfläche 1b" sind jeweils dünnere Schichten aus einem Metallfasern enthaltenden Verbund vorgesehen. Die obere Schicht ist 2a, die untere Schicht ist 2b. Diese beiden Schichten werden gelötet. Jeweils eine Lotschicht 9 ist an jeder Oberfläche jeder Ausgleichsschicht vorgesehen. Sie dienen dem Auffangen von thermischen Spannungen zwischen dem Leistungshalbleiter und den metallischen Anschlußflächen. Außerdem dienen sie der Durchleitung von thermischer Energie sowie der Durchleitung von elektrischem Strom.

Es versteht sich, daß der Leistungshalbleiter 3 eine obere und eine untere Oberfläche 3a,3b aufweist, die beide lötfähig sind. Die untere Oberfläche 3b ist die Substratseite, gerichtet zum Substrat 1b, das hier ein Metallsubstrat mit Wärmekapazität und Wärmeleitfähigkeit ist. Es handelt sich bei dem Aufbau nach Figur 1 um einen Aufbau für eine Diode, wobei die Randzonen der Oberfläche von der Berührung mit der textilen metallischen Dehnungsschicht ausgenommen werden. Dies kann durch die Randgestaltung oder durch Hinzufügen einer Isolationsschicht erreicht werden.

Mit dem Aufbau von Figur 1 ist bei **Figur 2** eine Reihenschaltung mehrerer Dioden vorgesehen. Ein erstes Metallsubstrat 1a entspricht demjenigen von Figur 1. Das mittlere Metallsubstrat 1b kann ebenfalls mit demjenigen von Figur 1 verglichen werden. Ein neues, weiter unten liegendes Metallsubstrat 1c mit Oberfläche 1c" kommt hinzu. Jeweils zwischen zwei Metallsubstraten ist ein Sandwich-Aufbau aus zwei Ausgleichsschichten 2a,2b bzw. 2c,2d diesseits und jenseits des jeweiligen Halbleiters 3 bzw. 4 als flächiger Leistungshalbleiter vorgesehen.

Durch jeweilige Lötschichten 9, die in Figur 2 nicht eingezeichnet sind, aber entsprechend Figur 1 dort auch vorgesehen sind, werden mechanische Kräfte zwischen den zu verbindenden Teilen aufgebracht, so daß eine zusätzliche mechanische Druckspannung nicht unbedingt nötig ist. Der Aufbau kann aber auch ohne Lotschichten 9 erfolgen, wenn eine solche mechanische Kraft hinzutritt. Es spricht nichts dagegen, auch beide Elemente zu verwenden, die durch Lötung erreichte Kraft und die durch eine mechanische Pressung erreichte Kraft.

**Figur 3** veranschaulicht das Beispiel von Figur 1 mit mehreren parallel geschalteten Halbleitern 4,5,6,7 und 8. Sie sind alle in derselben Ebene angeordnet. Oberhalb und unterhalb ist eine aus den metallischen Fasern gebildete Ausgleichsschicht 4a bzw. 4b vorgesehen. Beide sind an Kühlsubstrate 1a, 1b über Lötschichten 9 gekoppelt, wobei sowohl Wärme wie auch elektrischer Strom hindurchgeleitet werden kann. Eingezeichnet ist, wie auch in Figur 1, die Stärke d der Ausgleichsschichten. Diese ist deutlich geringer, als die Stärke des Halbleiters 3 und wird gebildet aus im Verbund zusammenhängenden Fasern.

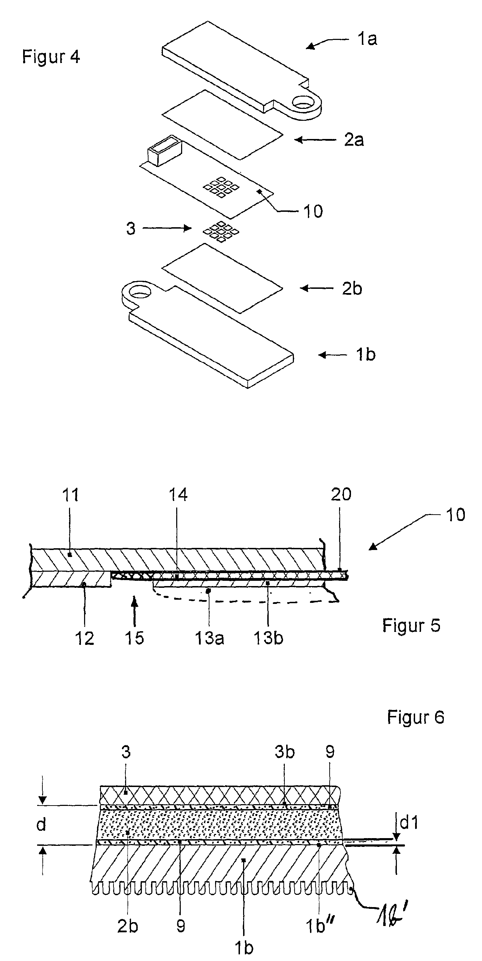

Der Faserzusammenhang kann ein Vlies, ein Nadelfilz oder eine gepreßte Kupferwolle sein. Die Fasern sind Metallfasern, beispielsweise Kupferfasern oder andere Metall-Liegierungen. Es kann aber auch ein Gemisch aus mehreren Metallen für die Fasern Verwendung finden. Diese Fasern sind lötfähig, sie sind also in der Lage, das Lot 9 als eine Schicht aufzunehmen und ein Stück weit in die Tiefe der Stärke d zu geleiten, wobei ein Mittelbereich verbleibt, der nicht verlötet wird. Diese Entstehung einer aus Faser gebildeten Zwischenschicht sowie zweier, oberhalb und unterhalb davon angeordneter Lötschichten 9 zeigt die **Figur 6.**

### Beispiele von Faserzusammenstellungen sind folgende:

In Figur 6 ist die Eindringtiefe d1 gezeigt, die geringer ist, als die Stärke d der Ausgleichsschicht. Die Faserstruktur ist symbolisch dargestellt, wobei oberhalb der Leistungshalbleiter 3 und unterhalb das Kühlsubstrat 1b angeordnet sind.

Die Lötschicht 9 ist auf beiden Oberflächen der Figur 6 mit einer Stärke d1 eingezeichnet, angrenzend an den obenliegenden Halbleiter 3 und angrenzend an das untere Kühlsubstrat 1b. Sie ist eine mechanische Verbindungsschicht, gleichzeitig eine elektrisch leitfähige Kopplung und ebenfalls eine die Wärme leitende Verbindung. Sie dringt bis zu einer Tiefe d1 in die Faserschicht aus Metallfasern ein und fixiert diese im Bereich ihres Eindringens. Das erstarrte Lot dringt so ein deutliches Stück weit in die Metallfaserschicht ein, wobei die Eindringtiefe geringer ist, als die Stärke d der Ausgleichsschicht. Die Eindringtiefe ist allerdings größer, als diejenige Eindringtiefe, die die Lötschicht in die Oberfläche des Halbleiters und die Oberfläche des Kühlsubstrates durch Diffusion bei der Lötung bewirkt.

Handelt es sich bei dem zu plazierenden Halbleiter-Bauelement um ein solches mit mehr als einem elektrischen Anschluß an der Oberfläche, wie in **Figur 4** dargestellt, so wird dieser zusätzliche Anschluß isoliert von der übrigen durch Lot bewirkten Anbindung, also unabhängig davon kontaktiert. Dieser zusätzliche Anschluß an dem schematisch durch seine Anschlußflächen eingezeichneten Halbleiter 3 erfolgt durch eine flache Verbindungsstruktur 10. Diese ist in **Figur 5** vergrößert und im Querschnitt herausgezeichnet. Sie ist ein Sandwich, bei dem zwischen zwei Isolationsfolien 11,12 eine Metallschicht 14 laminiert ist, die die Kontaktierung vornimmt. Die flache Verbindungsschicht 10 hat an einer Stelle 15 eine nach unten gerichtete Öffnung, durch die eine mit Lot vorgesehene Kontaktierung zu der Kontaktstelle des Halbleiters 3 erfolgt. Die doppelseitig isolierte Verbindungsschicht nach Figur 5 ist bevorzugt kleiner oder schmäler als die Ausgleichsschichten 2a,2b, um sich zwischen benachbarte Oberflächen von Halbleiter und einer der Ausgleichsschichten 2b einzufügen, bei Zulassung einer im übrigen vorgesehenen und durch Lot bewirkten Anbindung.

Aus Figur 5 ist ersichtlich, daß die metallische Schicht 14 als Verbindungsleiter bis zum äußeren Anschluß 20 dazu führt, daß die Isolierung 12 dort, wo sie die metallische Lage 14 bedeckt, leicht erhöht ist, wie strichliniert bei 13a dargestellt. Diese leichte Erhöhung wird durch eine Verwirkarbeit der Ausgleichsschicht 2b ohne weiteres aufgenommen. Es kann statt einer leichten Erhöhung des Abschnitts 13a der unten isolierenden Folie aber auch eine Kompression dieser Isolierschicht so stattfinden, daß die Folienhöhe der übrigen Fläche 12 und diejenige komprimierte Folienhöhe 13b, die oberhalb des streifenförmigen Leiters 14 liegt, vergleichmäßigt ist. Es ist also nur eine Schicht 13a oder 13b oberhalb von der Leiterbahn 14 vorgesehen.

Mehrere Halbleiter werden in Figur 3 zusammengeschaltet gezeigt und zwar in horizontaler Richtung. Mehrere Halbleiter sind auch zusammengeschaltet in vertikaler Richtung, dargestellt in Figur 2. Gemäß Figur 3 werden die mehreren Halbleiter, die als ein großes Array aus einem Wafer gesägt wurden, so zusammengeschaltet, als wären sie ein großer Halbleiter mit einer Gesamtfläche, die der Summe der Einzelhalbleiter 4,5,6,7 und 8 entspricht. Die Halbleiter 4 bis 8 werden durch die metalltextilen Ausgleichsschichten 4a,4b alle elektrisch parallel geschaltet. Hierdurch können die Halbleiter besonders kompakt aufgebaut werden, da kein lateraler Abstand zwischen den Halbleitern notwendig ist. Das hat für die in Figur 3 dargestellten Dioden Geltung. Sollen Halbleiter verbunden und angeschlossen werden, die zusätzliche Steueranschlüsse besitzen, also z.B. Leistungstransistoren oder Thyristoren, so wird dieser jeweilige Anschluß durch die in Figur 5 beschriebene doppelseitig isolierte Anschlußfolie 10 mit einem innenliegenden Leiter 14 realisiert. Der Leiter kann flächig als Folie oder Bahn ausgestaltet sein.

Die Sandwich-Struktur des Leistungsaufbaus mit den nachgiebigen (elastischen) metallischen textilen Zwischenlagen ermöglicht es, alle elektrischen Verbindungen gleichzeitig zu realisieren. Dies führt zu einer erheblichen Kostensenkung beim Herstellen des Leistungsaufbaus. Die textilen metallischen Ausgleichsschichten (auch Dehnungsschichten genannt) erzeugen während des Lötvorgangs einen gleichmäßigen flächigen Druck auf die Lötstellen, auch auf solche Lötstellen, die zusätzliche zu kontaktieren sind, wie anhand von Figur 5 und Figur 4 erläutert. Dieser gleichmäßige, flächige Druck führt zu besonders sicheren Lötverbindungen.

Eine so plazierte und fixierte metalltextile Ausgleichsschicht, mit den im Verbund stehenden Fasern, kann den mechanischen Streß in allen Richtungen reduzieren.

Der Aufbau von Figur 2 mit gestapelten mehreren Strukturen von Figur 1 wird bevorzugt in Brückenschaltungen verwendet. Sie erlaubt es, Dioden oder Transistorbrücken besonders kompakt, preiswert und zuverlässig aufzubauen. Die jeweilige Kontaktierung der Zwischenflächen zwischen den seriell geschalteten Halbleitern erfolgt durch die Metallstrukturen 1a, 1b und 1c, die seitlich über die Fläche der Halbleiter 3,4 herausstehen, wobei ein abwechselndes Herausstehen nach links, rechts, oder auch nach den anderen beiden Seiten des Halbleiterstapels möglich ist.

## Patentansprüche

1. **Vorrichtung** mit zumindest einem flächigen Halbleiter (3,4,5) für die Leistungselektronik und einem zur Wärmeaufnahme oder Wärmeabfuhr geeigneten Metallsubstrat (1a, 1b, 1c),
- wobei das Metallsubstrat eine für eine Lötung (9) ausgebildete und dem flächigen Halbleiter zugewandte Oberfläche (1b") aufweist;
- wobei der flächige Halbleiter zumindest eine Substratseite (3b) aufweist, die zur lötfähigen Oberfläche (1b") ausgerichtet ist;
und zwischen der zumindest einen Substratseite (3b) und der lötfähigen Metalloberfläche (1b") eine Ausgleichsschicht (2a,2b) angeordnet ist,
***dadurch gekennzeichnet**, daß*
die Ausgleichsschicht (2a,2b) einen Anteil an metallischen, lötfähigen Fasern aufweist, zur Verbindung zumindest eines flächigen Abschnitts der zumindest einen Substratseite (3b) des flächigen Halbleiters (3) mit einer ersten Oberfläche der Ausgleichsschicht (2a,2b) und der Oberfläche (1b") des Metallsubstrats (1b) mit einer zweiten Oberfläche der Ausgleichsschicht (2a,2b).

2. Vorrichtung nach Anspruch 1, wobei die Lötung (9) zur Bildung einer Lotschicht führt und an der einen und/oder der anderen Oberfläche der Ausgleichsschicht (2b) ein Stück weit (d1) in die Ausgleichsschicht eindringt, unter Ausbildung einer aus erstarrtem Lot gebildeten Zwischenlage, wobei die Eindringtiefe (d1) geringer ist, als eine Stärke (d) der Ausgleichsschicht, aber größer als eine Diffusion der Lotschicht (9) in die lötfähige Oberfläche (1 b") des Metallsubstrats.

3. Vorrichtung nach Anspruch 1, wobei die zumindest eine Ausgleichsschicht (2a,2b) als Faserzusammenstellung ausgebildet ist, welche Fasern Metallfasern sind und durch ihre Zusammenstellung in einem inneren Verbund stehen.

4. Vorrichtung nach Anspruch 1, wobei die zumindest eine Ausgleichsschicht (2a,2b) als eine Schicht aus Nadelfilz ausgebildet ist, welche Fasern aus Kupfer oder einer Kupferlegierung aufweist.

5. Vorrichtung nach Anspruch 1, wobei die Ausgleichsschicht eine gepreßte Schicht aus Kupferwolle ist.

6. Vorrichtung nach Anspruch 1, wobei die Ausgleichsschicht (2a,2b) als ein Verbund von zumindest teilweise aus Metall bestehenden Fasern gewebt, gewirkt oder geflochten ist oder als Gestrick oder Vlies ausgebildet ist.

7. Vorrichtung nach Anspruch 1, wobei durch die Lötung eine Lötschicht (9) ausgebildet ist, welche die zu verbindende Oberfläche (3b) des Halbleiters als eine leitende Oberfläche und die dem Halbleiter zugewandte Oberfläche (1b") des Metallsubstrats leitfähig verbindet, geeignet zum Stromtransport durch den Halbleiter.

8. Vorrichtung nach Anspruch 1, wobei mehrere Halbleiter (5,6,7,8) vorgesehen sind, die durch die Lötung mit einer Lötschicht (9) auf zumindest einer ihrer Oberflächen leitend miteinander und mit der Ausgleichsschicht (2a) verbunden sind.

9. Vorrichtung nach Anspruch 1, wobei die Ausgleichsschicht in ihrer Stärke (d) geringer ist, als die Stärke des Halbleiters (3).

10. Vorrichtung nach Anspruch 1, wobei eine weitere Ausgleichsschicht (2a) vorgesehen ist, die zwischen einer zweiten Oberfläche (3a) des Halbleiters und einer weiteren Oberfläche eines weiteren Metallsubstrats (1a) als zweiter Kühlkörper angeordnet ist.

11. Vorrichtung nach Anspruch 1, wobei eine weitere Ausgleichsschicht (2a) vorgesehen ist, die als eine Schicht ausgebildet ist, welche einen Anteil an metallischen, lötfähigen Fasern aufweist und jeweils durch eine Lötschicht (9) an jeweils einer von zwei Oberflächen der weiteren Ausgleichsschicht (2a) mit der benachbarten Oberfläche des Halbleiters bzw. einer Oberfläche (1a") eines weiteren Metallsubstrats (1a) verbunden ist.

12. Vorrichtung nach Anspruch 1 oder Anspruch 10, wobei der Halbleiter (3) an der Substratseite (3b), die der zumindest einen Ausgleichsschicht (2b) zugewandt ist, zumindest eine elektrische Kontaktfläche aufweist, zum Einleiten oder Steuern von Strom durch den flächigen Halbleiter (3).

13. Vorrichtung nach Anspruch 12, 7 oder Anspruch 1, wobei eine elektrische Kontaktfläche als zumindest ein Abschnitt der Substratseite (3b) von der Lötschicht (9) zwischen dem Halbleiter und dem Metallsubstrat (1b) stromtragfähig kontaktiert wird, um mit einem durch den Halbleiter im Betrieb fließenden Strom belastbar zu sein.

14. Vorrichtung nach Anspruch 1 oder Anspruch 12, wobei zumindest eine elektrische Kontaktfläche auf der Substratseite (3b) des Halbleiters vorgesehen ist und diese mittels einer zwischen der Substratseite und der metallischen Oberfläche (1b") angeordneten flächigen Leiterbahn (14,20) durch Löten stromtragfähig angeschlossen ist, wobei die Leiterbahn beidseitig flächig isoliert und nicht mit der metalltextilen Schicht (2a,2b) leitfähig verlötet ist.

15. Vorrichtung nach Anspruch 1, wobei zumindest ein weiterer elektrischer Anschluß als Kontaktfläche - insbesondere ein Steueranschluß des Halbleiters (3) - durch eine beidseitig isolierte flache Verbindung (10) mit offener einseitiger Öffnung (15) kontaktiert ist, um die elektrischen Anschlüsse des Halbleiters zwischen der Ausgleichsschicht und der Substratseite unabhängig von der übrigen Lötschicht (9) zu kontaktieren.

16. Vorrichtung nach Anspruch 1, bei der zumindest ein Halbleiter (3) in einen partiell metallisierten Kunststoffrahmen gelötet ist, der zumindest einen Anschluß (des zumindest einen Halbleiters) mit geringer Leistung kontaktiert.

17. Vorrichtung nach Anspruch 1, wobei der flächige Halbleiter (3,4,5) zumindest zwei elektrische Anschlüsse auf derselben Substratseite aufweist, von denen einer über die Lötschicht (9) zur Ausgleichsschicht (2b) kontaktiert ist und der zumindest eine andere Anschluß über eine beidseitig isolierte (11,12) Leiterbahn (14) in einer flachen Verbindungsschicht (10) kontaktiert ist, wobei eine der Isolationslagen (12) eine Öffnung (15) aufweist, die an der Stelle des zumindest einen weiteren Anschlusses des Halbleiters liegt, um hier durch eine Lötung mit dem Halbleiter verbunden zu werden.

18. Vorrichtung nach Anspruch 14 oder 17, wobei die flache Verbindungsschicht (10) eine wesentlich geringere Abmessung, insbesondere Breite, als die Ausgleichsschicht (2a,2b) aufweist.

19. **Verwendung** einer metalltextilen Ausgleichsschicht (2a,2b) oder einer Dehnungsschicht aus metallischen Fasern zur wärmeleitenden Kopplung eines Halbleiters (3,4,5) mit einem wärmeaufnehmenden oder -abführenden Wärmeleitkörper (1b, 1a), wobei Metallfasern in einem inneren Verbund zur Ausbildung einer zusammenhängenden textilen Schicht stehen.

20. **Leistungshalbleiteraufbau,** bestehend aus einem Halbleiterchip (3) mit unter dem Halbleiterchip lötfähiger Substratfläche (3b), wobei zwischen den Halbleiterchip und eine metallische Fläche (1b") eines Metallsubstrats (1a, 1b, 1c) eine textilmetallische Dehnungsschicht gelötet ist (9), zum Ausgleich einer unterschiedlichen thermischen Ausdehnung des Halbleiterchips gegenüber der metallischen Fläche.

21. Leistungshalbleiter nach Anspruch 20, wobei die Substratfläche (3b) des Halbleiterchips (3) nach unten gerichtet ist und mit einer nach oben zeigenden Oberfläche der metalltextilen Dehnungsschicht (2b) als Ausgleichsschicht zumindest bereichsweise verlötet ist (9).

22. Vorrichtung nach Anspruch 1, wobei die zumindest eine Ausgleichsschicht (2a,2b) eine textile metallische Schicht ist.

23. Vorrichtung nach Anspruch 1, wobei das zumindest eine Metallsubstrat (1b,1a) ein Kühlkörper ist, mit einer im wesentlichen ebenen inneren Kühloberfläche (1b",1a") und einer stark vergrößerten äußeren Kühlfläche.

24. Vorrichtung nach Anspruch 2, wobei die Lötschicht deutlich in die Ausgleichsschicht eindringt.

25. Vorrichtung nach einem der vorigen Ansprüche, wobei das zumindest eine Metallsubstrat flächig ist.

26. Vorrichtung nach Anspruch 1, wobei die eine oder die zwei Lotschichten (9) sich auf im wesentlichen der gesamten Oberfläche (3b) des flächigen Halbleiters erstreckt, die zur metallischen Oberfläche (1b") ausgerichtet ist.
